# EUROPÄISCHE PATENTSCHRIFT

(11) **EP 2 828 671 B1**
(45) Veröffentlichungstag und Bekanntmachung des Hinweises auf die Patenterteilung: **21.10.2015**
(21) Anmeldenummer: 13703608.3
(22) Anmeldetag: 12.02.2013
(51) Int. Cl.: G01P 21/00, B60R 21/013

(54) **BESCHLEUNIGUNGSSENSOR MIT MINDESTENS EINEM MIKROMECHANISCHEN SENSORELEMENT FÜR EIN INSASSENSCHUTZSYSTEM IN EINEM FAHRZEUG**
ACCELERATION SENSOR HAVING AT LEAST ONE MICROMECHANICAL SENSOR ELEMENT FOR AN OCCUPANT PROTECTION SYSTEM IN A VEHICLE
CAPTEUR D'ACCÉLÉRATION COMPRENANT AU MOINS UN ÉLÉMENT DE CAPTEUR MICROMÉCANIQUE POUR UN SYSTÈME DE PROTECTION DES PASSAGERS DANS UN VÉHICULE

(30) Priorität: 20.03.2012 DE 102012204438
(43) Veröffentlichungstag der Anmeldung: 28.01.2015
(73) Patentinhaber: Robert Bosch GmbH, 70442 Stuttgart (DE)
(72) Erfinder: WUCHERT, Thomas, 36466 Dermbach (DE)
(86) Internationale Anmeldenummer: PCT/EP2013/052781
(87) Internationale Veröffentlichungsnummer: WO 2013/139533

(56) Entgegenhaltungen:
- EP-A1- 2 088 043
- DE-A1- 10 306 707
- DE-A1- 19 705 406
- US-A1- 2010 179 722
- US-B1- 6 292 728

## Beschreibung

### Stand der Technik

Die Erfindung betrifft einen Beschleunigungssensor für ein Insassenschutzsystem in einem Fahrzeug, mit mindestens einem mikromechanischen Sensorelement zur Beschleunigungsaufnahme und mit einer elektronischen Auswerteeinheit, die für jedes Sensorelement einen redundanten Signalweg mit jeweils einem A/D-Wandler aufweist, wobei zur Plausibilisierung der Ausgangssignale des Beschleunigungssensors Mittel zur Überwachung von für die Funktionalität relevanten Parametern des mindestens einen A/D-Wandlers vorgesehen sind.

Ein gattungsgemäßer Beschleunigungssensor ist beispielsweise aus der DE 103 06 707 B4 bekannt.

Die US 6 292 728 B1, die US 2010/179722 A1 und die EP 2 088 043 A1 beschreiben die Verwendung von Pseudo- bzw. Test-Sensorsignalen zum Testen der Signalwege von Beschleunigungssensoren. Diese werden direkt in die zu den Beschleunigungssensoren gehörenden Signalwege geleitet.

Aus der DE 197 05 406 A1 ist bekannt, zum Testen eines A/D-Wandlers diesen mit einem bekannten Referenzsignal zu beaufschlagen und nachfolgend mit einer Grenze zu vergleichen.

Es ist allgemein bekannt, zum Schutz von Fahrzeuginsassen bei einer Kollision mittels Beschleunigungssensoren an verschiedenen Stellen im Fahrzeug Beschleunigungswerte zu erfassen und mittels eines Steuergerätes in Abhängigkeit von erfassten Beschleunigungswerten Rückhaltemittel wie Airbag und Gurtstraffer auszulösen. Das Schutzsystem muss allerdings hinsichtlich Störungen überwacht werden, da eine durch Störung bedingte, unerwünschte Auslösung von Rückhaltemitteln, insbesondere während der Fahrt, eine Gefährdung für die Insassen des Fahrzeugs und andere Personen mit sich bringen kann. Ursachen für solche Fehlauslösungen können schon auf der Ebene der Beschleunigungssensoren auftreten, beispielsweise elektromagnetische Einstrahlung, thermische Belastungen oder Störungen der Versorgungsspannung der Sensoren.

Um zu verhindern, dass es bereits auf der Ebene des Beschleunigungssensors zu einer Fehlauslösung eines Airbags kommt, ist es üblich, im Sensor zwei redundante mikromechanische Sensorelemente (MEMS: MicroElectroMechanical Systems) vorzusehen, die sich gegenseitig plausibilisieren. Wenn jedoch die von beiden Sensorelementen abgegebenen Signale mittels eines gemeinsam genutzten sensoreigenen A/D-Wandlers in den Mikrocontroller des Steuergerätes eingelesen werden, kann es bei einer Störung des A/D-Wandlers trotz redundanter Sensorelemente zu Fehlauslösungen kommen. Um dies zu verhindern, schlägt der oben genannte gattungsgemäße Stand der Technik vor, die Redundanz im Beschleunigungssensor auf den gesamten Signalweg zu erweitern, so dass für jedes Sensorelement ein eigener A/D-Wandler zur Verfügung steht. Da die A/D-Wandler sensibel auf ihre Umgebungs- beziehungsweise Betriebsbedingungen, wie zum Beispiel Versorgungsspannungsschwankungen, Temperatur oder Alterungs, reagieren, ist es jedoch ferner notwendig, die für beide A/D-Wandler gemeinsam genutzten, für die Funktionalität relevanten Parameter auf Einhaltung von spezifizierten Grenzen (beispielsweise hinsichtlich Unterspannung oder EMV-Störungen) zu überwachen. Ein Verlassen solcher Grenzen kann andernfalls - obwohl keine Beschleunigung vorliegt - in beiden Signalwegen zu einem Gleichtaktsignal und somit zu einem fehlerhaften Beschleunigungssignal führen. Die Realisierung einer derartigen Redundanz im Versorgungskonzept der A/D-Wandler beziehungsweise die Implementierung der erforderlichen Überwachungsmittel beziehungsweise Monitore, beispielsweise für Unterspannungserkennung, EMV-Erkennung, Referenzspannung und Stromerkennung für die A/D-Wandler, ist jedoch kosten- und chipflächenaufwändig.

### Offenbarung der Erfindung

Es ist daher Aufgabe der Erfindung, einen verbesserten, insbesondere vereinfachten Beschleunigungssensor der eingangs genannten Art zu schaffen.

Die Aufgabe der Erfindung wird durch den Beschleunigungssensor gemäß Patentanspruch 1 gelöst. Weitere vorteilhafte Ausgestaltungen der Erfindung ergeben sich aus den Unteransprüchen und der Beschreibung.

Bei dem erfindungsgemäßen Beschleunigungssensor umfassen die Überwachungsmittel eine in der Auswerteeinheit integrierte Ersatzschaltung für ein Sensorelement und einen redundanten, weiteren A/D-Wandler, der auf Änderungen der für die Funktionalität relevanten Parameter im gleichen Sinne reagiert wie der mindestens eine A/D-Wandler (4, 5). Der weitere A/D-Wandler (9) wandelt das feste, beschleunigungsunabhängige Ausgangssignal der Ersatzschaltung, wobei der Wert des digitalen Ausgangssignals des weiteren A/D-Wandlers (9) zur Feststellung von Änderungen der für die Funktionalität relevanten Parameter aller A/D-Wandler mittels eines Komparators (13) gegen eine vorgegebene feste Grenze (12) verglichen wird.

Der Erfindung liegt die Idee zu Grunde, einen redundanten Überwachungs-Signalweg zu implementieren, dessen Überwachungs- oder Sicherheits-A/D-Wandler auf Störungen, die die für die Funktionalität relevanten Parameter aller A/D-Wandler gleichermaßen betreffen, im gleichen Sinne reagiert, wie die Signal-A/D-Wandler. Eine Störung, die sich dem Ausgangssignal des Überwachungs-A/D-Wandlers aufprägt, ist aber, anders als bei den Ausgangssignalen der Signal-A/D-Wandler, leicht detektierbar, da sie nicht eventuell auf ein reales Beschleunigungssignal zurückgehen kann, sondern - aufgrund des festen, beschleunigungsunabhängigen Eingangssignals des Überwachungs-A/D-Wandlers, das von einer Ersatzschaltung generiert wird, die die Eigenschaften eines realen mikromechanischen Sensorelements, genauer: seinen Ruhezustand, kopiert beziehungsweise simuliert - unmittelbar die Störung abbildet. Sobald eine derartige Störung im Ausgangssignal des Überwachungs-A/D-Wandlers auftaucht, beziehungsweise sobald eine vorgebbare Toleranzschwelle überschritten wird, sind - in weiterer Folge - die Ausgangssignale der Signal-A/D-Wandler nicht mehr als plausibel, sondern als fehlerhaft zu bewerten.

Der Beschleunigungssensor der vorliegenden Erfindung hat den Vorteil, dass auf einfache Weise, im Wesentlichen durch Implementierung eines weiteren baugleichen A/D-Wandlers in die Auswerteeinheit, eine Redundanz hinsichtlich der Versorgung beziehungsweise der Überwachung realisiert, beziehungsweise die gemeinsame Situation der A/D-Wandler auf Einhaltung der vorgegebenen Grenzen plausibilisiert wird. Dadurch können Kosten durch Entwicklungsaufwand und Fläche auf dem ASIC der Auswerteeinheit eingespart werden.

Gemäß einer ersten Weiterbildung der Erfindung stellt der Beschleunigungssensor entweder das Resultat der Plausibilitätsprüfung zusammen mit den Ausgangssignalen zur externen Bewertung zur Verfügung, oder die Aussendung von intern als fehlerhaft bewerteten Ausgangssignalen des Beschleunigungssensors wird verhindert. Die Bewertung der Plausibilität kann also vorteilhaft wahlweise im externen Steuergerät oder im Beschleunigungssensor selbst vorgenommen werden.

Bei einer als besonders vorteilhaft angesehenen weiteren Weiterbildung der Erfindung ist in der Auswerteeinheit mindestens eine weitere Ersatzschaltung für ein Sensorelement integriert, die jeweils ein von der Ersatzschaltung verschiedenes festes Ausgangssignal generiert, so dass das Eingangssignal des weiteren A/D-Wandlers zur Prüfung der Funktionalität der Überwachungsmittel durch Umschalten von der Ersatzschaltung auf eine weitere Ersatzschaltung variierbar ist. .Auf diese Weise kann die Funktionalität der Überwachung beziehungsweise des Monitors für die für die Funktionalität relevanten Parameter selbst kontinuierlich geprüft werden.

Die Erfindung wird im Folgenden anhand von Ausführungsbeispielen näher beschrieben. Dabei zeigen

Figur 1 eine schematische Skizze, die die Komponenten und Funktionen einer Ausführung eines erfindungsgemäßen Beschleunigungssensors für einen Normalfall erläutert,

Figur 2, in gleicher Darstellung, eine Erläuterung für einen Fehlerfall.

Das folgende Ausführungsbeispiel geht von einem Airbag aus, dessen Auslösung mittels eines einzelnen Beschleunigungssensors mit zwei in einer so genannten 45-Grad-Applikation integrierten Sensorelementen plausibilisiert wird. Dabei wird die Beschleunigung im Fall eines Aufpralls mittels der beiden mikromechanischen Elemente (MEMS) (die auf einem ersten Chip des Beschleunigungssensors angeordnet sind) gemessen und dann von getrennten A/D-Wandlern auf einem ASIC (zweiter Chip des Beschleunigungssensors) gewandelt. Diese digitale Beschleunigungsinformation aus den beiden getrennten MEMS-Kanälen wird dem Airbag-Steuergerät zur Verarbeitung übermittelt und nach dessen Bewertung kann der Airbag gezündet werden. Damit es nicht durch Einzelfehler auf dem ASIC zu einem Gleichtakt- beziehungsweise Gegentaktsignal am Ausgang der beiden Kanäle des Sensors kommt, werden die Beschleunigungsinformationen auf dem ASIC in an sich bekannter Weise durch räumlich getrennte A/D-Wandler geführt.

Um die gemeinsamen Umgebungsbedingungen beziehungsweise Eingangsparameter der beiden Signal-A/D-Wandler hinsichtlich der Generierung fehlerhafter Signale zu überwachen, wird zur Überwachung erfindungsgemäß eine direkte Kopie der Signal-A/D-Wandler, also ein dritter A/D-Wandler verwendet, der, räumlich getrennt von dem ersten und zweiten A/D-Wandler, ebenfalls auf dem ASIC implementiert ist. Dadurch wird sichergestellt, dass die Reaktion dieses Überwachungs-A/D-Wandlers auf Umgebungs- beziehungsweise Betriebsparameteränderungen gleichsinnig zu den Änderungen ausfällt, die die gestörten Signal-A/D-Wandler ihren jeweiligen Eingangssignalen aufprägen. Der dritte, Überwachungs-A/D-Wandler wandelt dabei das (hinsichtlich Beschleunigungen natürlich) gleichbleibende, jedoch von den für die Funktionalität relevanten Parametern abhängige Signal einer auf dem ASIC in Form einer Ersatzschaltung vorgehaltenen Kopie der MEMS-Elemente. Da die mikromechanischen Sensorelemente zur Beschleunigungsaufnahme typischerweise eine in Oberflächenmikromechanik erzeugte unbewegliche und bewegliche Kammstruktur aufweisen, die zusammen einen Kondensator mit beschleunigungsabhängig veränderlicher Kapazität bilden, weist die Ersatzschaltung für die 'Sensorelementkopie' vorzugsweise die gleiche (jedoch unveränderliche) Kapazität C wie das originale mikromechanische Sensorelement im Ruhezustand auf. Die Ersatzschaltung kann ferner einen Widerstand R aufweisen, der so bemessen ist, dass der Überwachungs-A/D-Wandler die gleiche Impedanz wie bei einem realen Sensorelement sieht.

Der gewandelte Wert am Ausgang des dritten A/D-Wandlers wird dann gegen eine feste Grenze verglichen. Kommt es zum Beispiel zum Ausfall der Referenzspannung aller A/D-Wandler, so führt dies in den Signal-A/D-Wandlem zu einer Gleichtaktbeschleunigung, ohne dass - mangels Beschleunigung - Signale am Eingang der Signal-A/D-Wandler anliegen. Da der Überwachungs-A/D-Wandler an den gleichen Referenzen liegt, wird dieser ebenso einen Sprung im Ausgangssignal zeigen. Dieser Sprung würde die zuvor eingestellte Toleranzgrenze überschreiten und die digitale Beschleunigungsinformation der Signal-A/D-Wandler demnach nicht plausibilisieren, sondern als fehlerhaft markieren. Somit kommt es nicht zu einer Fehlauslösung des Airbags. Weiter lassen sich neben dem Ausfall von gemeinsam genutzten Referenzspannungen folgende weitere wichtige gemeinsame Parameter der Signal-A/D-Wandler überwachen:
- Peaks und Rauschen auf der Versorgung, zum Beispiel durch EMV
- Empfindlichkeitsänderungen der Signal-A/D-Wandler durch Temperatur oder Alterung
- alle gemeinsam genutzten Spannungen und Ströme

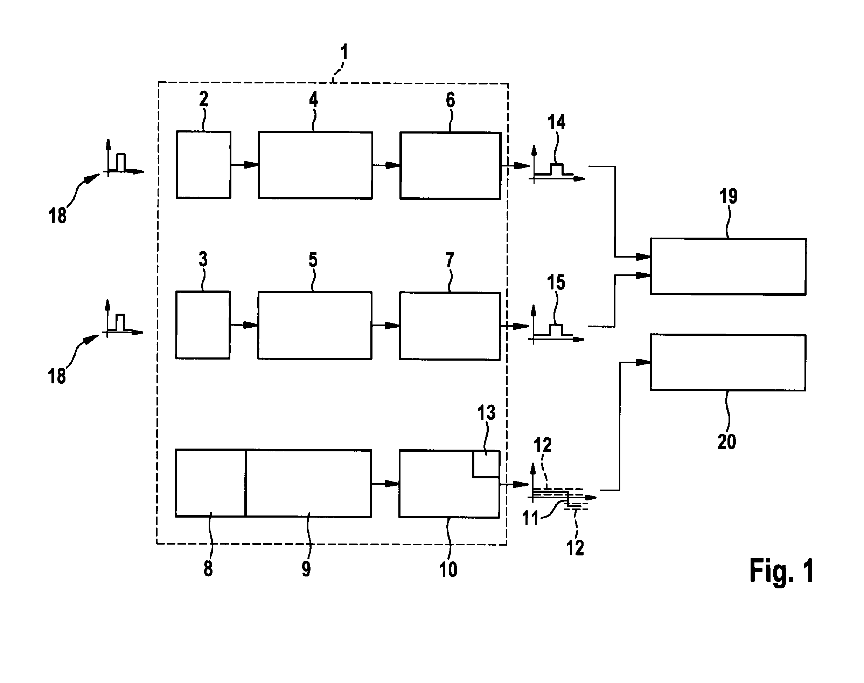

In Figur 1 ist ein Normalfall dargestellt, bei dem eine Beschleunigung vorliegt. Die real vorliegende Beschleunigung ist im linken Teil von Figur 1 in Form von außerhalb des Beschleunigungssensors 1 gezeichneten kleinen Beschleunigungsdiagrammen 18 angedeutet. Das zugehörige Beschleunigungssignal wird im ersten mikromechanischen Sensorelement 2 generiert, im zugehörigen ersten A/D-Wandler 4, der diesem MEMS-Kanal beziehungsweise Signalweg zugeordnet ist, gewandelt und von den Mitteln 6 digital aufbereitet (Filterung beziehungsweise Schnittstellenfunktionen). Ein redundant ausgestalteter zweiter MEMS-Kanal beziehungsweise zweiter Signalweg mit dem zweiten Sensorelement 3, dem zugehörigen zweiten A/D-Wandler 5 und den Mitteln 7 zur digitalen Signalverarbeitung ist ebenfalls dargestellt. Beide Kanäle des Sensors 1 generieren im dargestellten Fall korrekterweise das gleiche, plausibilisierte Ausgangssignal 14 und 15 (vergleiche das im rechten Teil der Figur 1 jeweils angedeutete digitale Datenwort). In hier angenommenen Normalfall (Beschleunigung; keine Störung) generiert die Ersatzschaltung 8 den vorgesehenen, beschleunigungsunabhängigen Standardwert, der vom Überwachungs-A/D-Wandler 9 gewandelt und von den Mitteln 10, insbesondere einen Komparator 13, darauf überprüft wird, ob das zugehörige Ausgangssignal 11 innerhalb der vorgegebenen Toleranzgrenzen 12 liegt. Dies ist hier der Fall, da gemäß Annahme keine Störung, das heißt, keine anormalen beziehungsweise geänderten für die Funktionalität relevanten Parameter, auf die der dritte A/D-Wandler 9 reagieren könnte, vorliegt. Die drei A/D-Wandler 4, 5 und 9 können im Übrigen vorteilhaft als an sich bekannte so genannte Sigma-Delta-Modulatoren ausgebildet sein.

In weiterer Folge werden die digitalen Ausgangssignale 14 und 15 zusammen mit dem Überwachungs-Signal 11 an ein externes Steuergerät übermittelt. Dort können in einer Einheit 20 die beiden Ausgangssignale 14 und 15 aufgrund des Überwachungs-Signals 11 als plausibel bewertet und in einer weiteren Einheit 19 gegebenenfalls noch gegenseitig plausibilisiert werden. Die Bewertung aufgrund des Überwachungs-Signals 11 kann jedoch auch sensorintern erfolgen, so dass der Beschleunigungssensor 1 überhaupt nur plausibilisierte Ausgangssignale 14 und 15 aussendet.

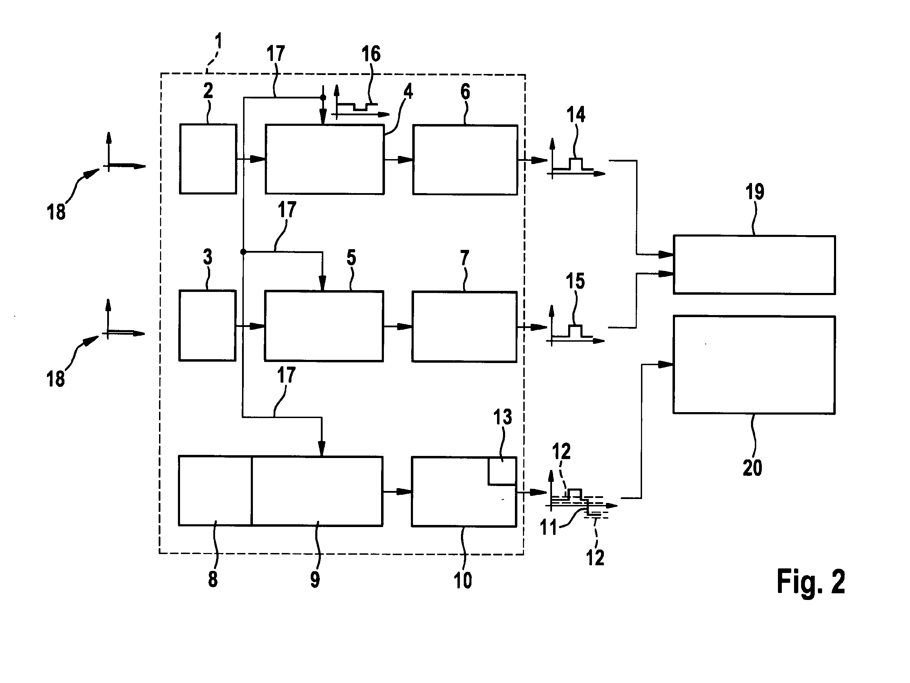

In Figur 2 ist, in gleicher Darstellung wie in Figur 1, ein Fehlerfall dargestellt, bei dem keine Beschleunigung vorliegt, die Signale am Ausgang der Signal-A/D-Wandler 4 und 5 also durch eine Störung, genauer: eine in Figur 2 angedeutete Spannungsschwankung 16, ausgelöst werden. Diese Spannungsschwankung 16 liegt, wie dargestellt, über die Versorgungsanschlüsse 17, in gleicher Weise an allen A/D-Wandlern 4, 5 und 9 an. Da beide Signal-Kanäle 2, 4, 6 und 3, 5, 7 des Sensors 1 in gleicher Weise betroffen sind, würde die gegenseitige Plausibilisierung einen Auslösefall ergeben. Da gleichzeitig das Ausgangssignal 11 des ebenfalls der gleichen Störung 16 unterliegenden Überwachungs-A/D-Wandlers 9 aufgrund der Störung 16 seine festgelegten Grenzen 12, wie in Figur 2 erkennbar, überschreitet, ergibt diese - intern oder extern durchführbare - Plausibilitätsprüfung jedoch korrekterweise, dass tatsächlich kein Auslösefall vorliegt.

Tatsächlich würde die Bewertung - gemäß Annahme des Vorliegens einer Störung - analog (das heißt: kein Auslösefall!) auch dann erfolgen, wenn zusätzlich auch eine reale Beschleunigung vorliegen würde, so dass in diesem Fall die realen Ausgangssignale 14, 15 durch die Störung 16 maskiert würden.

In der Auswerteeinheit kann vorteilhaft mindestens eine weitere Ersatzschaltung für ein Sensorelement integriert sein, die jeweils ein von der Ersatzschaltung 8 verschiedenes festes Ausgangssignal generiert. Somit ist das Eingangssignal des weiteren A/D-Wandlers 9 durch Umschalten von der Ersatzschaltung 8 auf eine weitere Ersatzschaltung variierbar, wodurch eine Prüfung der Funktionalität der Überwachungsmittel 8, 9, 13 erfolgen kann. Mithilfe der weiteren Ersatzschaltung wird quasi eine wählbare Störung, die allein auf den redundanten Überwachungs-Signalweg einwirkt, induziert.

## Patentansprüche

1. Beschleunigungssensor (1) für ein Insassenschutzsystem in einem Fahrzeug, mit mindestens einem mikromechanischen Sensorelement (2, 3) zur Beschleunigungsaufnahme und mit einer elektronischen Auswerteeinheit, die für jedes Sensorelement (2, 3) einen redundanten Signalweg mit jeweils einem A/D-Wandler (4, 5) aufweist, wobei zur Plausibilisierung der Ausgangssignale (14, 15) des Beschleunigungssensors (1) Mittel (8, 9, 10) zur Überwachung von für die Funktionalität relevanten Parametern des mindestens einen A/D-Wandlers (4, 5) vorgesehen sind,
**dadurch gekennzeichnet, dass**
die Überwachungsmittel (8, 9, 10) eine in der Auswerteeinheit integrierte Ersatzschaltung (8) für ein Sensorelement (2, 3) und einen redundanten, weiteren A/D-Wandler (9) umfassen, der so eingerichtet ist, dass er auf Änderungen der für die Funktionalität relevanten Parameter im gleichen Sinne reagiert wie der mindestens eine A/D-Wandler (4, 5), dass der weitere A/D-Wandler (9) so eingerichtet ist, dass er das feste, beschleunigungsunabhängige Ausgangssignal der Ersatzschaltung wandelt, und dass die Überwachungsmittel (8, 9, 10) einen Komparator (13) umfassen, der so eingerichtet ist, dass den Wert des digitalen Ausgangssignals des weiteren A/D-Wandlers (9) zur Feststellung von Änderungen der für die Funktionalität relevanten Parameter aller A/D-Wandler gegen eine vorgegebene feste Grenze (12) vergleicht.

2. Beschleunigungssensor (1) nach Anspruch 1, **dadurch gekennzeichnet, dass** der Beschleunigungssensor (1) das Resultat der Plausibilitätsprüfung zusammen mit den Ausgangssignalen (14, 15) zur externen Bewertung zur Verfügung stellt, oder die Aussendung von intern als fehlerhaft bewerteten Ausgangssignalen (14, 15) des Beschleunigungssensors (1) verhindert.

3. Beschleunigungssensor (1) nach Anspruch 1 oder 2, **dadurch gekennzeichnet, dass** in der Auswerteeinheit mindestens eine weitere Ersatzschaltung für ein Sensorelement (2, 3) integriert ist, die jeweils ein von der Ersatzschaltung (8) verschiedenes festes Ausgangssignal generiert, und dass das Eingangssignal des weiteren A/D-Wandlers (9) zur Prüfung der Funktionalität der Überwachungsmittel (8, 9, 13) durch Umschalten von der Ersatzschaltung (8) auf eine weitere Ersatzschaltung variierbar ist.

4. Beschleunigungssensor (1) nach einem der Ansprüche 1 bis 3, **dadurch gekennzeichnet, dass** der Beschleunigungssensor (1) als Zweikanal-Sensor ausgebildet ist, dessen zwei redundant angeordnete Sensorelemente (2, 3) eine unterschiedliche Sensierrichtung aufweisen.

5. Beschleunigungssensor (1) nach Anspruch 4, **dadurch gekennzeichnet, dass** der Zweikanal-Sensor zwei Sensorelemente (2, 3) in V-förmiger Anordnung aufweist, die insbesondere jeweils um 45° plus/minus zur Symmetrieachse verdreht sind.

6. Beschleunigungssensor (1) nach einem der Ansprüche 1 bis 5, **dadurch gekennzeichnet, dass** die mikromechanischen Sensorelemente (2, 3) in einem ersten Chip und die Auswerteeinheit in einem zweiten, als ASIC ausgebildeten Chip realisiert ist.

7. Beschleunigungssensor nach einem der Ansprüche 1 bis 6, **dadurch gekennzeichnet, dass** die drei A/D-Wandler (4, 5, 9) jeweils als Sigma-Delta-Modulator ausgebildet sind.

## Claims

1. Acceleration sensor (1) for an occupant protection system in a vehicle, having at least one micromechanical sensor element (2, 3) for sensing the acceleration and having an electronic evaluation unit which has a redundant signal path for each sensor element (2, 3), each signal path having a A/D converter (4, 5), wherein in order to check the plausibility of the output signals (14, 15) of the acceleration sensor (1) means (8, 9, 10) for monitoring parameters of at least one A/D converter (4, 5) which are relevant to the functionality are provided,
**characterized in that**
the monitoring means (8, 9, 10) comprise an equivalent circuit (8), integrated in the evaluation unit, for a sensor element (2, 3) and a redundant further A/D converter (9) which is configured in such a way that it reacts to changes in the parameters which are relevant to the functionality, in the same way as the at least one A/D converter (4, 5), **in that** the further A/D converter (9) is configured in such a way that it converts the fixed acceleration-independent output signal of the equivalent circuit, and **in that** the monitoring means (8, 9, 10) comprise a comparator (13) which is configured in such a way that it compares the value of the digital output signal of the further A/D converter (9) with a predefined fixed limit (12) in order to detect changes in the parameters of all the A/D converters which are relevant to the functionality.

2. Acceleration sensor (1) according to Claim 1, **characterized in that** the acceleration sensor (1) makes available the result of the plausibility checking together with the output signals (14, 15) for external assessment, or prevents the emission of output signals (14, 15) of the acceleration sensor (1) which are assessed internally as being faulty.

3. Acceleration sensor (1) according to Claim 1 or 2, **characterized in that** at least one further equivalent circuit for a sensor element (2, 3) is integrated into the evaluation unit, said further equivalent circuit generating in each case a fixed output signal which is different from the equivalent circuit (8), and **in that** the input signal of the further A/D converter (9) can be varied to check the functionality of the monitoring means (8, 9, 10) by switching over from the equivalent circuit (8) to a further equivalent circuit.

4. Acceleration sensor (1) according to one of Claims 1 to 3, **characterized in that** the acceleration sensor (1) is embodied as a two-channel sensor whose two sensor elements (2, 3) which are arranged redundantly have a different sensing device.

5. Acceleration sensor (1) according to Claim 4, **characterized in that** the two-channel sensor has two sensor elements (2, 3) in a V-shaped arrangement, which sensor elements are, in particular, each rotated by 45° plus/minus with respect to the axis of symmetry.

6. Acceleration sensor (1) according to one of Claims 1 to 5, **characterized in that** the micromechanical sensor elements (2, 3) are implemented in a first chip, and the evaluation unit is implemented in a second chip which is embodied as ASIC.

7. Acceleration sensor according to one of Claims 1 to 6, **characterized in that** the three A/D converters (4, 5, 9) are each embodied as a sigma-delta modulator.

## Revendications

1. Capteur d'accélération (1) pour un système de protection des passagers dans un véhicule, avec au moins un élément capteur (2, 3) micromécanique pour l'enregistrement de l'accélération et avec une unité d'évaluation électronique, qui pour chaque élément capteur (2, 3) comporte un trajet de signaux redondant avec chaque fois un convertisseur A/D (4, 5), alors que pour la plausibilisation des signaux de sortie (14, 15) du capteur d'accélération (1) sont prévus des moyens (8, 9, 10) pour la supervision de paramètres déterminants en matière de fonctionnalité de l'au moins un convertisseur A/D (4, 5),
**caractérisé en ce que**
les moyens de supervision (8, 9, 10) comportent un circuit de remplacement (8) pour un élément capteur (2, 3) intégré dans l'unité d'évaluation et un convertisseur A/D (9) redondant supplémentaire qui est conçu de sorte à réagir à des modifications des paramètres déterminants en matière de fonctionnalité, dans le même sens que l'au moins un convertisseur A/D (4, 5), **en ce que** le convertisseur A/D (9) supplémentaire est conçu de sorte à convertir des signaux de sortie fixes, indépendants de l'accélération du circuit de remplacement et **en ce que** les moyens de supervision (8, 9, 10) comprennent un comparateur (13) qui est conçu de sorte à comparer la valeur du signal de sortie numérique du convertisseur A/D (9) supplémentaire, pour constater des modifications des paramètres déterminants pour la fonctionnalité de tous les convertisseurs A/D par rapport à une limite fixe (12) prédéfinie.

2. Capteur d'accélération (1) selon la revendication 1, **caractérisé en ce que** le capteur d'accélération (1) met à disposition pour une évaluation externe le résultat de la vérification de plausibilité, en commun avec les signaux de sortie (14, 15), ou empêche l'émission de signaux de sortie (14, 15) du capteur d'accélération (1) qui ont été évalués en interne comme étant erronés.

3. Capteur d'accélération (1) selon la revendication 1 ou 2, **caractérisé en ce que** dans l'unité d'évaluation est intégré au moins un circuit de remplacement supplémentaire pour un élément capteur (2, 3) qui génère respectivement un signal de sortie fixe, différent de celui du circuit de remplacement supplémentaire (8) et **en ce que** pour vérifier la fonctionnalité des moyens de supervision (8, 9, 10), le signal d'entrée du convertisseur A/D (9) supplémentaire est variable par commutation du circuit de remplacement (8) sur un circuit de remplacement supplémentaire.

4. Capteur d'accélération (1) selon l'une quelconque des revendications 1 à 3, **caractérisé en ce que** le capteur d'accélération (1) est réalisé en tant que capteur à deux canaux, dont les deux éléments capteurs (2, 3) placés de manière redondante comportent un système capteur différent.

5. Capteur d'accélération (1) selon la revendication 4, **caractérisé en ce que** le capteur à deux canaux comporte deux éléments capteurs (2, 3) placés en forme de V, qui sont notamment tournés chacun de 45 ° plus/moins par rapport à l'axe de symétrie.

6. Capteur d'accélération (1) selon l'une quelconque des revendications 1 à 5, **caractérisé en ce que** les éléments capteurs (2, 3) micromécaniques sont réalisés dans une première puce et l'unité d'évaluation est réalisée dans une deuxième puce, réalisée en tant que puce ASIC.

7. Capteur d'accélération selon l'une quelconque des revendications 1 à 6, **caractérisé en ce que** les trois convertisseurs A/D (4, 5, 9) sont conçus chacun en tant que modulateur sigma-delta.
